# EUROPEAN PATENT SPECIFICATION

(11) **EP 0 514 140 B1**
(45) Date of publication and mention of the grant of the patent: **18.10.1995**
(21) Application number: 92304277.4
(22) Date of filing: 12.05.1992
(51) Int. Cl.: H05K 9/00, H01L 39/14

(54) **Superconductor magnetic shield**
Supraleitende magnetische Abschirmung
Ecran magnétique supraconducteur

(30) Priority: 17.05.1991 JP 142380/91
(43) Date of publication of application: 19.11.1992
(73) Proprietor: Koatsu Gas Kogyo Co., Ltd., Osaka-shi (JP)
(72) Inventor: Sugioka, Takao, c/o Koatsu Gas Kogyo Co., Ltd., Osaka-shi (JP); Saji, Yoshiro, c/o Koatsu Gas Kogyo Co., Ltd., Osaka-shi (JP); Toda, Hiroaki, c/o Koatsu Gas Kogyo Co., Ltd., Osaka-shi (JP); Takagi, Tetsuo, c/o Koatsu Gas Kogyo Co., Ltd., Osaka-shi (JP); Inoue, Masaru, c/o Koatsu Gas Kogyo Co., Ltd., Osaka-shi (JP); Otani, Kohei, c/o Koatsu Gas Kogyo Co., Ltd., Osaka-shi (JP); Sato, Manabu, c/o Koatsu Gas Kogyo Co., Ltd., Osaka-shi (JP)
(74) Representative: Bowles, Sharon Margaret

(56) References cited:
- EP-A- 0 151 726
- EP-A- 0 190 767
- US-A- 4 828 931
- PATENT ABSTRACTS OF JAPAN vol. 014, no. 099 (E-0893)22 February 1990 & JP-A-1 302 799

## Description

The present invention relates to improvements in magnetic shields for shielding intense magnetic fields and more particularly to a magnetic shield having a large area to prevent magnetic leakage in wide ranges.

It is known to avoid adverse effects of magnetic fields generated from magnets or other substances by the use of magnetic shields which are made of plate-shaped or sheet-shaped superconductors refrigerated below a critical temperature. To achieve the object of shielding such magnetic fields, the second class superconductor which operates in the mixture region of the superconducting and normal conducting conditions is used more preferably than the first class superconductor, since the upper critical temperature of the second class superconductor is higher than that of the first class superconductor.

The maximum magnetic field shielding intensity of a superconductor, that is, the shielding intensity of a superconductor having a shape of a plate, sheet, film or membrane (generally described below simply as "layer") for completely shielding external magnetic fields is significantly dependent on the class, size and shape of the superconductor. As pointed out in the patent specifications cited below the maximum magnetic field shielding intensity of a superconductor increases abruptly as its thickness increases in a limited range. If the thickness increases above a certain value, the rate of increase of the maximum magnetic field shielding intensity becomes gentle. This indicates that an inflexion point is present on a curve which represents the relationship between the thickness of the superconductor and its maximum magnetic field shielding intensity. Considering this phenomenon, the inventors of the present invention have proposed a magnetic shield, the maximum magnetic field shielding intensity of which is significantly enhanced by using superconductor layers, the thickness of which is made smaller than that corresponding to the aforementiond point of the inflexion, by laminating a superconductor layer with a normal conductor layer such as aluminium foil and by increasing the number of laminated layers (JP-A-61-183979, US-A-4803452, CA-A-1261050, EP-A-86 101613. 7-2208).

The expansion of a magnetic shielding space by enlarging the area of a magnetic shield constituted by a single superconductor layer is limited owing to limitations in the production requirements of superconductors. In order to produce larger superconductor layers exceeding the limitation, it is known to mutually overlap the end margins of a plurality of oxide superconductor ceramic plates for example and to stick the end margins together with conductive adhesive (JP-A-63-313897) . The inventors of the present invention have also proposed a magnetic shield made by sticking a plurality of small superconductor pieces onto the external or internal surface of a cylinder with its one end closed (JP-A-1-302799).

These days, superconductor magnets are made larger to generate more intense magnetic fields. Because of this enlargement, the space ranges affected by the intense magnetic fields are also expanded. To shield unnecessary permeation by intense magnetic fields, magnetic shields which can securely shield intense magnetic fields over large areas have been requested. Such magnetic shields are applied to superconductor motors and superconductor generators, as well as superconductor magnets themselves used in linear motor cars and electromagnetic propellant ships.

The maximum magnetic field shielding intensity of a plate-shaped (i.e. laminar) magnetic shield for completely shielding a magnetic field is apt to become lower at the external peripheral margin than at the central region of the magnetic shield. In the case of a disc-shaped magnetic shield for example, the maximum magnetic field shielding intensity is lower at its peripheral margin than at its central region. For this reason, although complete shielding is possible at the central region, magnetic flux permeates the outer peripheral margin, causing magnetic leakage. Consequently, to completely shield a constant external magnetic field permeating a surface, shielding is necessary at the central region of the magnetic shielding plate by using a magnetic shield having the maximum magnetic shielding amount exceeding the external magnetic field intensity generated at the periphery of the surface area. As a result, the size of the magnetic shield must be considerably larger than the permeated surface.

A serious problem in the magnetic shielding process is the generation of a flux jump phenomenon wherein magnetic flux permeating the outer peripheral margin of the magnetic shield flows abruptly to the central region of the magnetic shield. If this occurs, the magnetic shield is heated locally and its superconducting condition is converted into a normal conducting condition, thereby causing magnetic field leakage over the entire magnetic shield. Even if this flux jump occurs only once, the magnetic shield cannot act as a superconductor and completely loses its magnetic shielding function. Since the amount of generated heat is greater as the transfer distance of magnetic flux is larger, it is difficult to maintain a stable superconducting condition in an intense magnetic field.

In the above-mentioned magnetic shield, which is made large by mutually laminating and sticking a plurality of superconductor ceramic plates, superconductive shielding current flows across every two ceramic plates. The structure of the magnetic shield is thus considered to be the same as that comprising a single superconductor, thereby being liable to lose the magnetic shielding effect due to the generation of a flux jump.

In the case of a tubular magnetic shield formed by pressing and sticking superconductor pieces (comprising superconductive low-melting-point alloy powder) onto the surface of a tube, the structure of this magnetic shield is the same as that of a tube formed to have a large surface area and made from a single superconductor, since the adjacent superconductor pieces are joined by the superconductor alloy. Accordingly, the maximum magnetic shielding amount of the magnetic shield is lower at the upper peripheral margin of the opening area of the tube and lowest at the sealed end region of the bottom of the tube, causing the danger of losing the magnetic shielding effect due to the generation of the flux jump at such a region.

As a countermeasure for reducing the effect of the flux jump, a plurality of small through holes are provided in the surface area of a thin superconductor film such that the transfer range of the magnetic flux is limited to reduce heating and prevent a chain reaction of magnetic flux flow (JP-A-63-233577, US-A-4828931, CA-B-1296089, GB-A-2203909, DE-A-38-09452, FR-A-8803822). Even when a magnetic shield is enlarged, however, there remains the problem of reduction in the maximum magnetic field shielding intensity at its peripheral margin.

It is known from JP-A-1302799 to provide a superconductor magnetic shield comprising thin superconductor films each of which is wound as a closed ring on a tubular former. The ring-shaped films are axially offset so that each ring-shaped film overlaps its immediate neighbour.

### Summary of the Invention

It is therefore one object of the present invention to provide a magnetic shield capable of compensating for the reduction of the maximum magnetic shielding amount at the peripheral region of the magnetic shield and also capable of effectively shielding an intense magnetic field over a large surface area of the magnetic shield, and to prevent superconductivity from being lost owing to the generation of a flux jump related to the enlargement of the magnetic shield, thereby to ensure stability of the magnetic shield.

A second object of the present invention is to provide a superconductor magnetic shield capable of achieving completely zero magnetic field intensity even in the presence of a locally intense magnetic field so that the magnetic shield can cope with the spatial change in the magnetic field intensity in an non-uniform magnetic field.

The invention provides a superconductor magnetic shield comprising a plurality of superconductor layers successively stacked in non-direct contact over a common substrate, each layer comprising a multiplicity of independent laminar superconductor units, the laminar units within each individual layer being disposed either to be closely adjacent or to overlap neighbouring laminar units of the same layer and the laminar units of each layer having peripheral sections which overlap laminar units of an adjacent superconductor layer.

### Brief Description of the Drawings

Fig. 1(A) shows a generally radial distribution of the maximum magnetic field shielding intensity of a disc-shaped laminar superconductor unit. Fig. 1(B) shows the relationship between external magnetic field intensity and the magnetic shielding amount of the laminar superconductor unit.

Fig. 2 is a sectional view of a single layer of magnetic shield formed by overlapping the peripheral margins of rectangular thin laminar superconductor units and also shows the distribution of the maximum magnetic field shielding intensity at the illustrated cross-section.

Fig. 3 is a plan view of a magnetic shield made by stacking a plurality of layers each comprising square superconductor units.

Fig. 4(A) and Fig. 4(B) are respectively a plan view and a vertical sectional view of a magnetic shield made by sticking layers each comprising disc-shaped superconductor units.

Fig. 5(A) is a plan view of a single layer composed of abutted and stuck square laminar superconductor units, and Fig. 5(B) and Fig. 5(C) are respectively a plan view and a vertical sectional view of a magnetic shield with two vertically arranged layers each comprising a multiplicity of laminar superconductor units as shown in Fig. 5(A).

Fig. 6(A) is a plan view of a superconductor layer comprising abutted and stuck disc-shaped laminar superconductor units and Fig. 6(B) is a plan view of three layers each composed of disc-shaped superconductor units as shown in Fig. 6(A).

Fig. 7 is a vertical section of a container-shaped magnetic shield, the internal surface of which is covered with a plurality of layers each comprising laminar superconductor units.

Fig. 8 is an outline sectional view of an apparatus for testing the magnetic characteristics of the magnetic shield shown in Fig. 7.

### Detailed Description

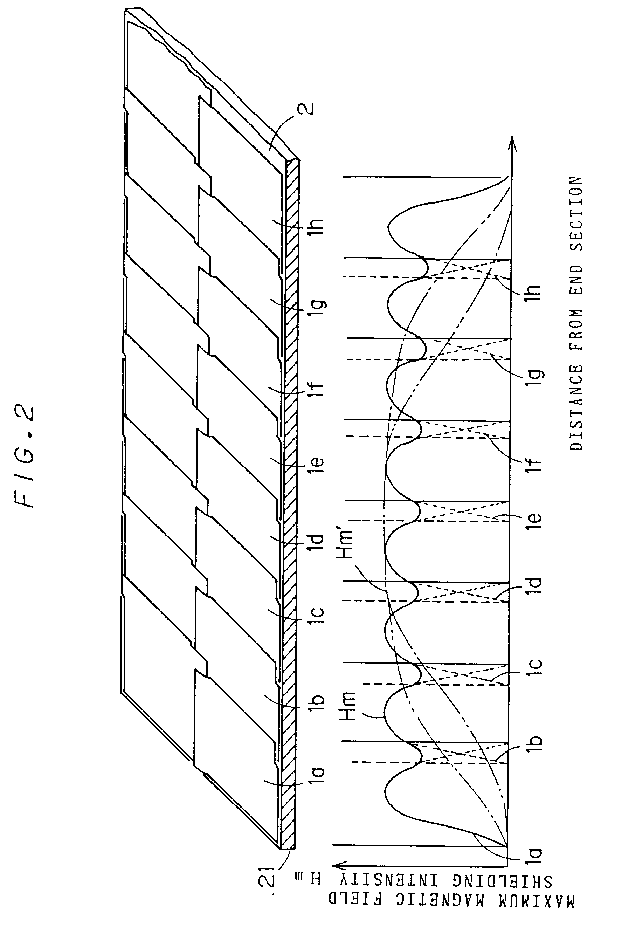

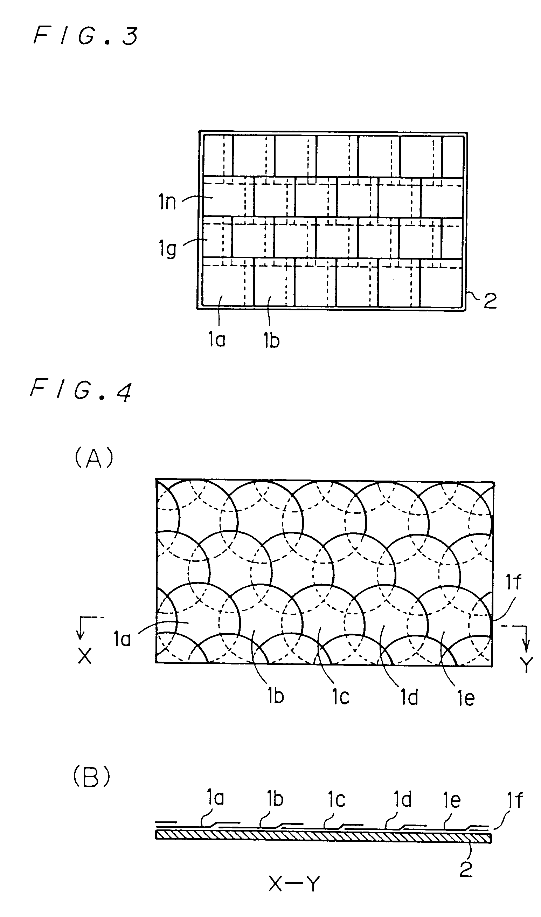

A superconductor magnetic shield according to the present invention claimed herein can be generally classified into those embodiments in which the laminar units are in abutting contact with or proximate to the neighbouring units within each layer and the laminar units of each layer overlap laminar units of an adjacent layer, as shown in Figs. 3 and 4, and those embodiments in which the laminar units overlap within each layer as shown in Fig. 2 as well as between adjacent layers, as explained hereinafter.

First, the technical matters common to the various embodiments are described below.

A substrate is formed in accordance with the desired shape of the superconductor magnetic shield and is determined considering the shape of the superconductor magnet to be covered and the space to be shielded. The substrate is mainly made of a non-magnetic normal conductor material, such as copper, aluminium, stainless steel or low-temperature synthetic resin and is formed into a shape of a flat plate, curved plate or container.

Each laminar superconductor unit layer may be a film or plate made of a superconductor material. Although it can be a single thin superconductor plate, it preferably comprises laminations of thin superconductor plates and thin non-magnetic metal plates.

As a superconductor material, Nb-Ti alloy, mixed crystal of NbN and TiN, Nb₃Al, Nb₃Ge, Nb₃ (Al, Ge), Nb₃Sn, Y-Ba-Cu-O-based oxide, Bi-Sr-Pb-Ca-Cu-O-based oxide or Tl-Sr-Ca-Cu-O-based oxide may be used.

Each laminar superconductor unit may have a simple shape of a square, hexagon or circle. An appropriate size for the laminar unit is 5 to 100 cm in diameter in the case of a circle.

The laminar units are stuck together with low-temperature organic adhesive or normal conductor low-melting-point alloy onto the surface of the above-mentioned substrate. When sticking laminar units from a superconductor layer, the peripheral margins of the unit layers may mutually overlap to prevent formation of any gap which is not covered by a laminar unit as viewed in the direction normal to the surface of the substrate and thereby to completely cover the substrate. In this case, it is important that the overlap is performed so that the peripheral margin of each laminar unit does not make contact with those of other adjacent units. To accomplish this, the adhesion layer formed by the above-mentioned adhesive should be insulated, or organic insulation films should be interposed between the overlapping margins or the front and rear surfaces of the superconductor units should be a lamination covered with normal conductor metal, such as copper film or aluminium film.

To form two or more layers comprising the superconductor units and to stack the layers on the above-mentioned substrate, the laminar units are stuck sequentially onto the lower superconductor layer with the above-mentioned adhesive or normal conductor low-melting-point alloy. At the time of this process, although the thin superconductor units of the same layer can be abutted and arranged such that there are gaps between the units, the superconductor units of the second layer must be arranged in the direction normal to the substrate such that they cover the gaps between the units in the first layer.

In addition, an electrical insulating layer or a normal conductor layer should be interposed in the same manner as described above such that the superconductor units of the first and second layers do not make contact with each other.

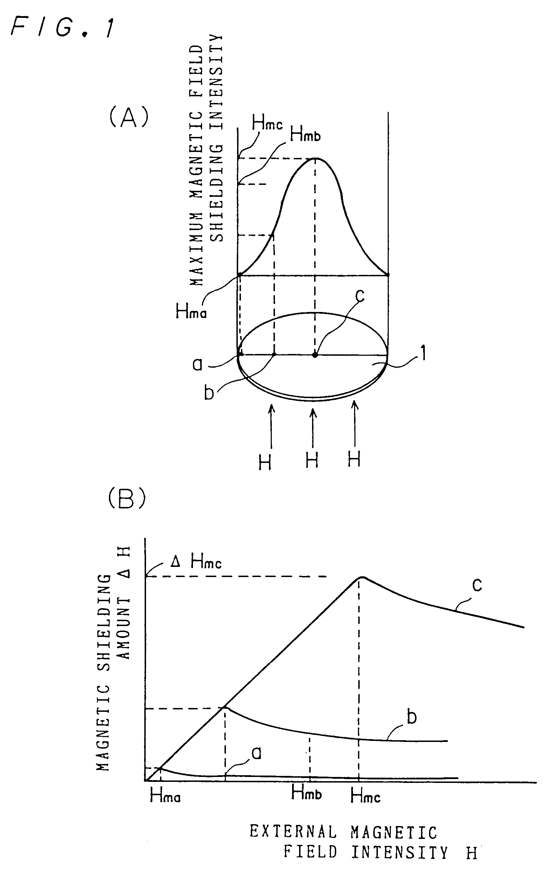

Generally, a superconductor sheet, for example, a disc-shaped superconductor unit does not have uniform magnetic shielding capability over its entire surface. The maximum magnetic field shielding intensity Hm of the superconductor at the time of complete shielding of an external magnetic field is highest at the center of the disc. The intensity lessens towards the outer portion and becomes zero at the outer periphery of the disc. The maximum magnetic field shielding intensity of the disc-shaped superconductor as a function of radius is shown as a skirt-shaped curve as shown in Fig. 1(A). Fig. 1(B) shows the relationship between an external magnetic field intensity and a magnetic shielding amount ΔH (a difference between the magnetic field intensity obtained when a magnetic shield is present at a measurement position and that obtained when the magnetic shield is absent) measured in the radial direction from the centre c to the periphery a of the disc-shaped superconductor. According to the figure, the magnetic shielding amount at the centre c is equal to the external magnetic field intensity in response to the initial increase of the external magnetic field intensity and the magnetic field does not permeate the superconductor. However, if the external magnetic field intensity becomes greater than the maximum magnetic shielding amount ΔH, the magnetic shielding amount ΔH becomes smaller. In other words, if the external magnetic field intensity is greater than the maximum magnetic shielding amount ΔHm, the magnetic flux of the magnetic field penetrates the superconductor. When the maximum magnetic shielding amount ΔHm is assumed to be the maximum magnetic field shielding intensity Hm, the value of Hm becomes smaller at positions farther away from the centre of the disc and becomes zero at the periphery, resulting in no magnetic shielding capability.

The maximum magnetic field shielding intensity Hm at the facial centre of a sheet-shaped superconductor varies according to the type, structure and thickness of the superconductor. When a disc-shaped superconductor unit is taken as an example, the intensity Hm generally increases abruptly as the disc diameter increases up to about 50 cm. The value increases more gradually as the diameter increases further. For this reason, the superconductor unit is limited to a small size of 5 to 100 cm in diameter.

A magnetic shield layer as shown in Fig. 2 is made by arranging and sticking small laminar superconductor units onto the surface of the substrate while vertically overlapping the external peripheral margins of the superconductor units while ensuring that the adjacent superconductor units do not make contact with one another. With this structure, the maximum magnetic field shielding intensity at the overlapping margins is the sum of the magnetic field shielding intensity of the upper superconductor unit and that of the lower superconductor unit as shown in Fig. 2. By relatively expanding the width of the overlapping sections, the maximum magnetic field shielding intensity values at all positions over the surface of the magnetic shield are made uniformly greater than a certain value. For this reason, when a large-area magnetic shield is formed by laminating a plurality of small superconductor units such that they make contact with one another, the maximum magnetic field shielding intensity of the magnetic shield reduces in the wide range of the peripheral regions of the superconductor as shown by the Hm' curve in Fig. 2. As a result, the external magnetic field cannot be shielded completely and magnetic field leakage occurs. To solve this problem, a magnetic shield with a surface area far wider than the surface area of the external magnetic field to be shielded is required. However, the magnetic shield of the present invention has a magnetic shielding capability even at its peripheral regions except very close to its periphery as high as the capability obtained at its central region, as indicated by the Hm curve shown in Fig. 2. The surface area of the magnetic shield can thus be made approximately equal to that of the external magnetic field to be shielded.

When in accordance with the invention a layer formed on the substrate by overlapping the peripheral margins of the superconductor unit layers is further laminated with another superconductor layer to form two layers, while the upper and lower laminar superconductor units are maintained in a non-contact manner and while the overlapping margin of each lower unit is positioned over the central region of a corresponding upper laminar unit, the distribution of the maximum magnetic field shielding intensity of the magnetic shield is made more uniform. To further flatten the distribution, three or more layers should be used.

In another form of the invention, laminar superconductor units are laminated in two or more layers on the substrate, and adjacent units within each layer are proximate to or abutted against each other, as shown in Figs. 3 to 6. The peripheral margin of each superconductor unit of a first layer is overlapped by one of the superconductor units of a second layer. As a result, the maximum magnetic field shielding intensity of the superconductor unit located just above the peripheral margin of another superconductor unit is added to the low maximum magnetic field shielding intensity of the peripheral margin, thereby obtaining the maximum magnetic field shielding intensity that is larger than a certain level over the entire surface of the magnetic shield.

In a magnetic shield according to this aspect of the invention, there would be no magnetic shielding capability where adjacent units abut voids between adjacent units if only one layer comprising superconductor units were used. By laminating a second layer of superconductor units over the first layer, the lack of magnetic field shielding capability at the abutments or voids of the first and second layers can be compensated.

Since a magnetic shield according to the present invention is formed by sticking a plurality of superconductor units onto the surface of a substrate while maintaining them in non-direct contact in the direction normal to the substrate, the shielding current for preventing the intrusion of external magnetic fields flows only inside a corresponding laminar unit, which is isolated from adjacent laminar units.

With this structure, even if flux jump (as previously described) occurs, the mutual action between the magnetic flux and the shielding current is contained within the corresponding unit and the chain reaction of the flux jump is also contained within the corresponding unit, thereby causing no adverse effect to other adjacent superconductor units. Since the size of the laminar unit can be made small, the transfer distance of the magnetic flux can also be made small. Even when magnetic flux flow occurs frequently, the heating of the unit is limited. Even if the temperature of the unit increases, the unit can be refrigerated by immersion in a refrigerant such as liquid helium. This minimizes the possibility of raising the temperature of the unit above its critical temperature, the possbility of converting the unit into a normal conductor and the possibility of losing the magnetic shielding effect of the unit. For this reason, the present invention can form a large-area magnetic shield which rarely experiences unstable conditions due to flux jump.

In particular, when a superconductor laminar unit is laminated with a normal conductor metal lamina, the normal conductor metal lamina blocks the flow of the above-mentioned shielding current of the laminar unit and isolates each superconductor layer. When aluminium, particularly copper or silver, is used as the metal, the superior heat conductivity of such metal is significantly effective in externally dispersing the heat generated by the flow of magnetic flux and thus also effective in refrigerating the layers, thereby effectively preventing instability due to the flow of the magnetic flux.

When a superconductor laminar unit consists of a single lamina, it usually comprises rolled Nb-Ti alloy foil with a thickness of 100 µm or less. As the thickness is larger, the maximum magnetic field shielding intensity of the superconductor layer becomes greater. However, if the thickness increases to 20 µm or more, the rate of increase of the maximum magnetic field shielding intensity reduces. This increasing of the thickness is thus not advantageous. Rather than using a thicker foil, a laminated comprising Nb-Ti alloy foil of 20 µm or less in thickness and normal conductor foil such as copper or aluminium foil should be used. Increasing the number of laminations is advantageous, since the maximum magnetic shielding amount can be made larger. A laminated unit comprising Nb-Ti alloy foil and a normal conductor foil can be made by sputtering. The sputtering method is also used when the laminated unit is formed from the mixed crystal of NbN and TiN. More specifically, the above-mentioned sputtering method is conducted on one or two kinds of metal layers selected from the group consisting of copper, aluminium, nickel, stainless steel, titanium, niobium and niobium-titanium alloy to form the lamination. When forming the superconductor unit from Nb₃Al, Nb₃Ge, Nb₃ (Al, Ge) and Nb₃Sn, the thin films formed by the sputtering method or the like can be used. In addition, films which are heat-treated after rolling and lamination can be used. As the normal conductor lamina, one or two kinds of metal layers selected from the group consisting of copper, aluminium, nickel, stainless steel and titanium can be used.

For the magnetic shield of the present invention, a plate-shaped superconductor can be used as one of the superconductor units. As the plate-shaped superconductor, a plate made of a Y-Ba-Cu-O-based oxide, Bi-Sr-Pb-Ca-Cu-O-based oxide or Tl-Sr-Ca-Cu-O-based oxide an be used. In addition, a sintered plate of 0.5 to 10 mm in thickness can also be used as the plate-shaped superconductor.

When a plurality of small through holes are provided in a superconductor unit, the transfer of the magnetic flux at the peripheral region of the unit is limited in the neighbourhood of the adjacent small holes and no flux jump occurs at the central region of the unit. The range of the flux jump can thus be contained within the space between the holes, thereby eliminating the danger of making the superconductor unstable. If the diameter of the holes is made larger, however, the magnetic shielding amount is lowered. The aperture of the holes should therefore be 3 cm² or less and preferably the diameter of the hole should be about 50 µm.

Since the present invention provides a large-area magnetic shield by sticking a plurality of layers of small superconductor units onto the substrate, each superconductor unit can have a small size of about 5 to 100 cm. Such superconductor units can thus be produced very easily. Furthermore, magnetic shields of larger sizes or with various curvatures can also be produced easily by sticking a plurality of units onto the substrates made by welding and assembling.

Moreover, since the magnetic characteristics of the laminar unit can be measured accurately and easily by ordinary test methods, the characteristics of an assembled magnetic shield can be estimated fairly accurately according to the magnetic data of the unit layer.

### Examples

Embodiments of the invention are explained below with reference to the drawings. Fig. 3 shows an example of a magnetic shield wherein square superconductor units 1a, 1b,... are disposed on a rectangular flat substrate 2 so that the peripheral margins of the units of one layer overlap those of another layer. As the superconductor units 1a, 1b,..., thin flexible alloy plates are appropriate, and particularly a single lamina of Nb-Ti alloy foil of 100 µm or less in thickness or a lamination of Nb-Ti alloy foil and aluminium foil of 20 µm or less in thickness can be used. Low-temperature organic adhesive (not shown) is used for sticking. An adhesive layer is interposed between the overlapping margins of the superconductor units such that the overlapping portions thereof do not make direct contact with each other. When using a lamination comprising the Nb-Ti alloy foil and aluminium foil, the front and rear surfaces of the lamination are covered with aluminium foil to prevent direct contact between the overlapping portions of the adjacent pieces of superconductor Nb-Ti alloy foil. This method is advantageous since the use of adhesive for preventing direct contact is unnecessary.

Fig. 4 illustrates an example of laminating and sticking disc-shaped superconductor units. For the superconductor units shown in Fig. 4, non-flexible thin oxide superconductor plates can also be used. An organic adhesive layer is interposed between the overlapping margins of the plates so that the laminar superconductor units do not make direct contact with each other at the overlapping regions.

The substrate 2 of the magnetic shield shown in Figs. 3 and 4 has a rectangular shape. By combining a plurality of such rectangular substrates, a container-shaped magnetic shield can be formed. Besides, since flexible superconductor sheets can be easily stuck onto a curved substrate, magnetic shields having desired shapes and large areas can be formed.

By stacking a plurality of layers each comprising laminar superconductor units of the same size as shown in Figs. 3 and 4, the magnetic field shielding intensity of the magnetic shield thus obtained can be enhanced and rendered uniform.

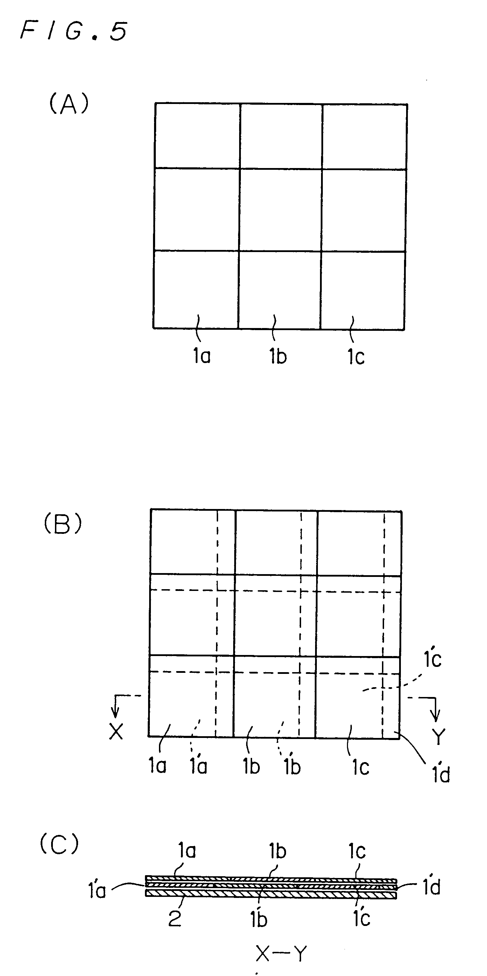

Fig. 5(A) shows an embodiment wherein square superconductor units are stuck with the peripheries thereof abutted. This example is applicable particularly to non-flexible rigid superconductor plates, for example the above-mentioned oxide superconductor plates. In this case, a small gap is provided between the abutted peripheries thereof to prevent adjacent superconductor units from making direct contact with one another and to allow an adhesive to intervene in the gap. In this example, the magnetic field shielding intensity at the abutting portions is approximately zero and magnetic leakage occurs. To solve this problem, the abutted and stuck superconductor plates must be laminated in two layers as shown in Fig. 5(B) and 5(C), and the abutting portions of the upper layer must be shifted in the surface direction so that the gaps of the upper layer do not coincide with those of the lower layer. To completely prevent magnetic shielding leakage and to render the magnetic field shielding intensity uniform, the lamination structure should have three or more layers.

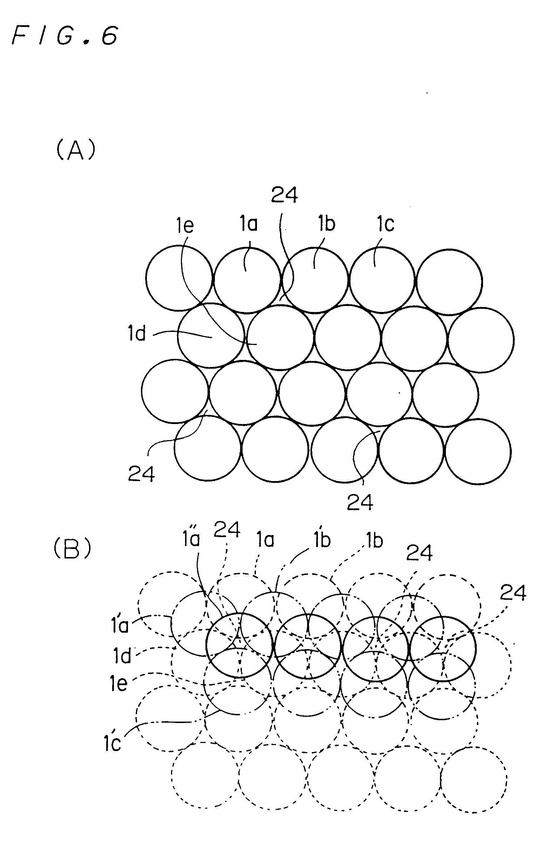

Fig. 6(A) shows one superconductor layer wherein laminar units comprising discs 1a, 1b,... are abutted and stuck together. In this case, even when the discs are packed as closely as possible, a substantial void portion 24 is formed among every three adjacent discs.

As shown in Fig. 6(B), the superconductor discs 1′a, 1′b,... of a second layer are stuck and arranged to cover the void portion 24 enclosed by every three adjacent discs of the above-mentioned first layer. Even in this two-layer structure, magnetic leakage still occurs at each position where a void portion 24 of the first layer coincides with a void portion 24 of the second layer. To prevent this leakage, superconductor discs 1˝a, 1˝b,... of a third layer are stuck to cover the void portions 24. By providing a structure comprising three or more such layers, the magnetic field shielding intensity of this example can be made uniform. This embodiment is suited particularly for fragile superconductor ceramics, since disc-shaped sintered products can be made easily.

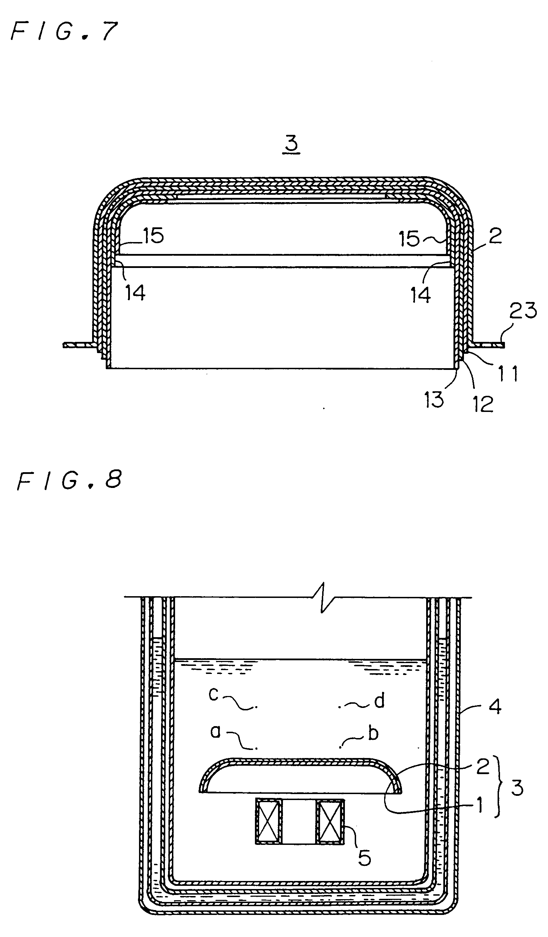

Fig. 7 shows a vertical sectional view of an upper part of a container-shaped magnetic shield wherein a plurality of layers each comprising plate-shaped superconductor ceramic units are stuck inside. The three layers 11, 12 and 13 each comprising ceramic plates are stuck onto the inside surface of the container-shaped copper substrate 2. Furthermore, two layers 14 and 15 are additionally stuck onto the corner sections of the substrate to shield the high magnetic field at the corners of the container.

Next, the production method and test results of the magnetic shields of the present invention are described below.

Superconductor units were produced as follows. A laminated plate having a total of 25 laminations was produced wherein each lamination was made by laminating Nb-Ti alloy and copper, which were alternately deposited by sputtering to a thickness of 0.4 µm on a copper plate having a thickness of 18 µm and a diameter of 30 mm. The plate was then cut into square units each having a side length of 50 mm.

The substrate was made of 5 mm thick copper plate. It was formed into the shape of a pan having a diameter of 400 mm, a flat bottom and curved external peripheral rims. Over the entire internal surface of the substrate, a 10 mm wide overlap of the units was provided as described with reference to Fig. 3, the units being stuck together with low-temperature epoxy adhesive to form a magnetic shield. Two superconductor layers were provided at the central flat section of the magnetic shield and five layers were used at the curved rims.

As shown in Fig. 8, a superconductor coil 5 was provided at a lower section of an adiabatic vacuum container 4 having an internal diameter of 500 mm. Over the coil, a pan-shaped magnetic shield 3 was disposed with its inner side facing downwards. The interior of the adiabatic container was filled with liquid helium to refrigerate the superconductor coil 5 and the magnetic shield 3. The magnetic field inside the container was measured at four positions a, b, c and d over the magnetic shield 3 by using a magnetic field measurement sensor.

The exciting current of the superconductor coil magnet 5 was first obtained so that the measured magnetic field intensity was 0.1 Tesla at the measurement points e and f without installing the magnetic shield 3. The magnetic shield 3 was then installed at the specified position, the same exciting current was caused to flow in the superconductor coil 5, and the magnetic field intensity values were 0.0005 Tesla or less at all the measurement positions a, b, c and d.

A magnetic shield made of an oxide represented by a chemical formula of Y_{1.0}Ba_{2.0}Cu_{3.0}O₇₋ₓ was then tested. A mixture of Y₂O₃, BaCO₃ and CuO was heated, melted and abruptly refrigerated, then pulverized. The powder obtained in this was was press-molded into a shape of a disc and fired to produce a plate-shaped superconductor. To form thin films from the oxide, the oxide powder was applied to or printed on a metal plate made of copper for example, then fired.

The fired superconductor discs measuring 50 mm in diameter and 5 mm in thickness were arranged in three layers as shown in Fig. 6 and stuck onto the internal surface of a pan-shaped substrate made of copper and having a thickness of 5 mm and an outer diameter of 400 mm as shown in Fig. 8. The magnetic shielding amount of this example was then measured using the above-mentioned testing apparatus. The maximum magnetic shielding amount of the example was 2 Tesla over 70% of the surface, including the central region of the pan-shaped substrate.

Consequently, magnetic shields according to the present invention can provide the following advantages.

Since a plurality of small superconductor laminar units can be stuck onto a substrate while being overlapped at their peripheral sections without allowing the units to make contact with one another and a large-area magnetic shield can be formed, the maximum magnetic field shielding intensity of the magnetic shield can be uniformized in the surface area of the magnetic shield without reduction of the intensity at its margins except very close to its periphery. Besides, the reduction of the maximum magnetic field shielding intensity which occurs at the external peripheral margins of a large-area magnetic shield formed by a continuous superconductor can be compensated for and prevented by the magnetic shield of the present invention. The size of the magnetic shield can thus be made almost as large as the extent of an external magnetic field to be shielded. The magnetic shield of the present invention can therefore be made relatively smaller than a magnetic shield formed by a continuous superconductor.

In addition, since two or more layers comprising superconductor units are used, the maximum magnetic field shielding intensity of a magnetic shield according to the present invention can be enhanced and made uniform in the external peripheral direction.

Furthermore, when a plurality of superconductor units are abutted and stuck at their peripheries sections and laminated to form two or more, particularly three or more layers, the magnetic leakage at the abutting sections can be prevented and the maximum magnetic field shielding intensity of the magnetic shield can be enhanced significantly.

In particular, since the number of the laminations can be increased at the margins of the magnetic shield, particularly in the limited regions exposed to high magnetic field intensity, the magnetic shield of the present invention can cope with changes in the intensity of local external magnetic fields, thereby easily achieving complete magnetic shielding.

Moreover, since the adjacent superconductor units are isolated so that they do not make contact with one another, the possibility of flux jump over the entire magnetic shield is eliminated. Even if flux jump occurs, it is confined to a small superconductor unit and heat generation is minimal, thereby reducing the danger of causing the superconductor shield to be converted into a normal conductor. In particular, when the superconductor units have a laminated structure comprising superconductor films and normal conductor films or when a plurality of small through holes are provided in the superconductor units, the factors for causing instability due to flux jump can be substantially eliminated and the reliability of the magnetic shield of the present invention can be enhanced significantly.

When the magnetic characteristics, size and shape as well as the sticking method and the number of laminations of the superconductor units are known, the magnetic shielding capability of a large-area magnetic shield can be estimated fairly accurately. In the case of a conventional magnetic shield, preliminary experimental testing of the shielding capability of a practially large magnetic shield is virtually impossible partly because larger testing apparatuses must be used. In the case of the magnetic shield of the present invention, it is possible to estimate the magnetic characteristics of the magnetic shield according to partial test results, since the instability due to the above-mentioned flux jump does not occur.

## Claims

1. A superconductor magnetic shield comprising a plurality of superconductor layers successively stacked in non-direct contact over a common substrate (2), each layer comprising a multiplicity of independent laminar superconductor units (1a,1b,etc.), the laminar units within each individual layer being disposed either to be closely adjacent or to overlap neighbouring laminar units of the same layer and the laminar units of each layer having peripheral sections which overlap laminar units of an adjacent superconductor layer.

2. A superconductor shield according to claim 1 in which the laminar units within an individual layer closely abut neighbouring laminar units in the same layer.

3. A superconductor shield according to claim 1 in which there are voids (24) formed among laminar units within an individual layer and these voids are covered by laminar units within another one of the superconductor layers.

4. A superconductor shield according to claim 1 in which the laminar units within an individual layer overlap neighbouring laminar units in the same layer.

5. A superconductor shield according to any foregoing claim in which the laminar units each comprise a superconducting lamination and a normally conducting lamination.

6. A superconductor magnetic shield according to any of claims 1 to 5 in which each laminar unit (la,lb) comprises a lamination of a mixed crystal of niobium nitride and titanium nitride on one or two kinds of metal layers, the metals being selected from the group consisting of copper, aluminium, nickel, stainless steel, titanium, niobium and sputtered niobium-titanium alloy.

7. A superconductor magnetic shield according to any foregoing claim in which adjacent superconductor layers are separated by an intervening non-superconducting material which comprises a normal conductor or an electric insulator.

8. A superconductor magnetic shield according to claim 7 in which the normal conductor layer comprises one or two kinds of metal layers, the metals being selected from the group consisting of copper, aluminium, nickel, stainless steel and titanium.

9. A superconducting magnetic shield according to claim 7 in which the electric insulator comprises an organic adhesive.

10. A superconductor magnetic shield according to any foregoing claims in which a plurality of small through holes are provided in the laminar units, passing through the laminar units from the front to the back surface thereof.

11. A superconductor magnetic shield according to any foregoing claim in which the superconductor laminar units comprise niobium-titanium alloy, mixed crystal of NbN and TiN, Nb₃AL, Nb₃Ge, Nb₃(AL,Ge), Nb₃Sn, Y-Ba-Cu-O based oxide, Bi-Sr-Pb-Ca-Cu-O based oxide or Tl-Sr-Ca-Cu-O based oxide.

12. A superconductor magnetic shield according to any foregoing claim, wherein there are three of said superconductor layers.

## Patentansprüche

1. Supraleitende magnetische Abschirmung mit einer Mehrzahl von Supraleiterlagen, die in mittelbarem Kontakt nacheinander über einem gemeinsamen Substrat (2) gestapelt sind, wobei jede Lage eine Vielzahl von unabhängigen laminaren Supraleitereinheiten (1a, 1b, etc.) aufweist, die laminaren Einheiten innerhalb jeder einzelnen Lage so angeordnet sind, daß sie an benachbarte laminare Einheiten derselben Lage eng angrenzen oder diese überlappen, und die laminaren Einheiten jeder Lage periphere Abschnitte aufweisen, die laminare Einheiten einer benachbarten Supraleiterlage überlappen.

2. Supraleitende Abschirmung nach Anspruch 1, bei der die laminaren Einheiten innerhalb einer einzelnen Lage an benachbarten laminaren Einheiten in derselben Lage eng anliegen.

3. Supraleitende Abschirmung nach Anspruch 1, bei der unter laminaren Einheiten innerhalb einer einzelnen Lage Zwischenräume (24) gebildet sind und diese Zwischenräume durch laminare Einheiten einer anderen der Supraleiterlagen abgedeckt sind.

4. Supraleitende Abschirmung nach Anspruch 1, bei der die laminaren Einheiten innerhalb einer einzelnen Lage benachbarte laminare Einheiten in derselben Lage überlappen.

5. Supraleitende Abschirmung nach einem der vorhergehenden Ansprüche, bei der die laminaren Einheiten jeweils eine supraleitende Laminierung und eine normal leitende Laminierung aufweisen.

6. Supraleitende magnetische Abschirmung nach einem der Ansprüche 1 bis 5, bei der jede laminare Einheit (1a, 1b) eine Laminierung aus einem Mischkristall aus Niobnitrid und Titannitrid auf einer oder zwei Arten von Metallagen aufweist, wobei die Metall aus der aus Kupfer, Aluminium, Nickel, rostfreiem Stahl, Titan, Niob und gesputterten Niob-Tantal-Legierungen ausgewählt sind.

7. Supraleitende magnetische Abschirmung nach einem der vorhergehenden Ansprüche, bei der benachbarte Supraleiterlagen durch ein dazwischenliegendes nicht supraleitendes Material getrennt sind, das einen normalen Leiter oder einen elektrischen Isolator aufweist.

8. Supraleitende magnetische Abschirmung nach Anspruch 7, bei der die normale Leiterlage eine oder zwei Arten von Metallagen aufweist, wobei die Metalle aus der aus Kupfer, Aluminium, Nickel, rostfreiem Stahl und Titan bestehenden Gruppe ausgewählt sind.

9. Supraleitende magnetische Abschirmung nach Anspruch 7, bei der der elektrische Isolator einen organischen Kleber aufweist.

10. Supraleitende magnetische Abschirmung nach einem der vorhergehenden Ansprüche, bei der in den laminaren Einheiten eine Mehrzahl von kleinen Durchgangslöchern vorgesehen ist, die durch die laminaren Einheiten von deren Vorderseite zur Rückseite durchgehen.

11. Supraleitende magnetische Abschirmung nach einem der vorhergehenden Ansprüche, bei der die laminaren Supraleitereinheiten Niob-Titanlegierungen, Mischkristalle aus NbN und TiN, Nb₃Al, Nb₃Ge, Nb₃(Al,Ge), Nb₃Sn, Oxide auf Y-Ba-Cu-O-Basis, Oxide auf Bi-Sr-Pb-Ca-Cu-O-Basis oder Oxide auf Tl-Sr-Ca-Cu-O-Basis aufweisen.

12. Supraleitende magnetische Abschirmung nach einem der vorhergehenden Ansprüche, bei der drei Supraleiterlagen vorgesehen sind.

## Revendications

1. Ecran magnétique supraconducteur comprenant une pluralité de couches supraconductrices empilées successivement sans contact direct sur un substrat commun (2), chaque couche comprenant une multiplicité de modules supraconducteur lamellaires indépendants (1a, 1b etc.), les modules lamellaires dans chaque couche individuelle étant disposés soit de manière à être étroitement adjacents soit à chevaucher des modules lamellaires voisins de la même couche, et les modules lamellaires de chaque couche ayant des sections périphériques qui chevauchent des modules lamellaires d'une couche supraconductrice adjacente.

2. Ecran supraconducteur selon la revendication 1, dans lequel les modules lamellaires dans une couche individuelle sont juxtaposés étroitement à des modules lamellaires voisins dans la même couche.

3. Ecran supraconducteur selon la revendication 1, dans lequel il existe des espaces vides (24) formés entre des modules lamellaires dans une couche individuelle et ces espaces vides sont recouverts par des modules lamellaires dans une autre des couches supraconductrices.

4. Ecran supraconducteur selon la revendication 1, dans lequel les modules lamellaires dans une couche individuelle chevauchent des modules lamellaires voisins dans la même couche.

5. Ecran supraconducteur selon l'une quelconque des revendications précédentes, dans lequel les modules lamellaires comprennent chacun une structure lamifiée supraconductrice et une structure lamifiée normalement conductrice.

6. Ecran supraconducteur selon l'une quelconque des revendications 1 à 5, dans lequel chaque module lamellaire (1a, 1b) comprend une structure lamifiée d'un cristal mélangé de nitrure de niobium et de nitrure de titane sur une ou deux sortes de couches métalliques, les métaux étant sélectionnés dans le groupe constitué du cuivre, de l'aluminium, du nickel, de l'acier inoxydable, du titane, du niobium et d'un alliage pulvérisé de niobium-titane.

7. Ecran supraconducteur selon l'une quelconque des revendications précédentes, dans lequel des couches supraconductrices adjacentes sont séparées par un matériau non supraconducteur intercalé qui comprend un conducteur normal ou un isolant électrique.

8. Ecran supraconducteur selon la revendication 7, dans lequel la couche conductrice normale comprend une ou deux sortes de couches métalliques, les métaux étant sélectionnés dans le groupe constitué du cuivre, de l'aluminium, du nickel, de l'acier inoxydable et du titane.

9. Ecran supraconducteur selon la revendication 7, dans lequel l'isolant électrique comprend un adhésif organique.

10. Ecran supraconducteur selon l'une quelconque des revendications précédentes, dans lequel une pluralité de petits trous traversants sont prévus dans les modules lamellaires, traversant les moules lamellaires de leur surface avant vers leur surface arrière.

11. Ecran supraconducteur selon l'une quelconque des revendications précédentes, dans lequel les modules lamellaires supraconducteurs comprennent un alliage de niobiumtitane, un cristal mélangé de NbN et de TiN, Nb₃Al, Nb₃Ge, Nb₃(Al,Ge), Nb₃Sn, un oxyde à base de Y-Ba-Cu-O, un oxyde à base de Bi-Sr-Pb-Ga-Cu-O ou un oxyde à base de Tl-Sr-Ca-Cu-O.

12. Ecran supraconducteur selon l'une quelconque des revendications précédentes, dans lequel il existe trois desdites couches supraconductrices.
